Europäisches Patentamt

European Patent Office

Office européen des brevets

(19)

(11) Numéro de publication: **0 477 453 A1**

## (12) DEMANDE DE BREVET EUROPEEN

(21) Numéro de dépôt: **90402627.5**

(22) Date de dépôt: **24.09.90**

(51) Int. Cl.5: **G01R 31/28**

(43) Date de publication de la demande:
**01.04.92 Bulletin 92/14**

(84) Etats contractants désignés:
**DE GB**

(71) Demandeur: **Office National d'Etudes et de Recherches Aérospatiales (O.N.E.R.A.) 29 Avenue de la Division Leclerc F-92320 Châtillon-sous-Bagneux(FR)**

(72) Inventeur: **Roizes, Alain**
**32, Rue A. Soumet**

**F-31500 Toulouse(FR)**
Inventeur: **David, Jean-Pierre**
**46, rue Romain Roland**
**F-31520 Ramonville Saint-Agne(FR)**
Inventeur: **Chourreau, Alain**
**12, rue Couli-Clos Stéphanie**
**F-31650 Saint-Orens(FR)**

(74) Mandataire: **Plaçais, Jean-Yves et al**
**Cabinet Netter, 40, rue Vignon**
**F-75009 Paris(FR)**

(54) **Installation de test, en particulier pour plaquettes de matériau semi-conducteur.**

(57) Une enceinte sous vide est définie par une plate-forme (10) surmontée d'une cloche (20) à fenêtre optique (21). Intérieurement, l'enceinte loge une table (30) dont le plateau inférieur reçoit un mécanisme de positionnement quatre axes (40), supportant un insert isolant (60) surmonté d'une tête à régulation de température portant une plaquette semi-conductrice (W). Le plateau supérieur (32) de la table reçoit des dispositifs porte-aiguilles susceptibles de venir en contact de manière ajustable sur des plots de contact de la plaquette (W) à des fins de test, tandis qu'un solénoïde plat (90), muni d'un écran isolant thermique, permet l'application d'un champ magnétique à la plaquette. Cet ensemble permet des mesures extrêmement sophistiquées sous excitations électrique, magnétique aussi bien qu'optique, à des températures allant de celle de l'azote liquide jusqu'à quelques centaines de degrés Celsius.

FIG.2

L'invention concerne les tests effectués lors de la fabrication de composants électroniques.

Les circuits intégrés monolithiques sont fabriqués comme suit : d'un bain de matériau semi-conducteur en fusion, on tire un lingot monocristallin ; dans ce lingot sont découpées des tranches fines dites plaquettes ou wafers ; les plaquettes font ensuite individuellement l'objet de traitements multiples visant à y créer des composants ayant une distribution tridimensionnelle choisie d'impuretés et selon un motif prédéterminé ; la plaquette est enfin découpée, selon ce motif géométrique, en puces ou chips, qui vont être le coeur du composant électronique.

En fabrication, il est nécessaire d'effectuer des tests non seulement sur des plaquettes terminées, mais aussi, en amont, au niveau du lingot. Par exemple, on prélève la première et la dernière plaquette découpées dans le lingot. Ces plaquettes font l'objet de traitements simplifiés, qui y réalisent des motifs dits de tests. L'étude du comportement de ces motifs de tests permet d'évaluer les caractéristiques électriques du matériau semi-conducteur après dopage.

Ces tests prennent une importance croissante, pour de nombreuses raisons. L'une de celles-ci est le fait que l'on tend à augmenter beaucoup la densité d'intégration et la complexité des circuits intégrés monolithiques. Leur coût de fabrication augmente donc. Il est alors d'autant plus important de vérifier, avant les étapes complexes de dopage, que le matériau de base est adéquat.

Par ailleurs ces tests permettent de mettre en évidence un phénomène dit " effet substrat" qui a été observé en particulier sur des matériaux III-V de la classification périodique, tels que l'arséniure de gallium. En bref, ce phénomène réside en ce que deux transistors voisins peuvent perdre leur indépendance électrique à des températures plus basses que la température ambiante, ou égales à celle-ci.

Plus généralement, il est souhaitable de pouvoir effectuer des contrôles poussés sur la qualité de la structure cristalline du matériau semi-conducteur de base et des impuretés électriquement actives, et sur l'aptitude du composant à fonctionner correctement dans des gammes de températures très étendues.

La présente invention vise essentiellement à apporter une solution à ce problème.

Ainsi, le premier but de l'invention est de fournir une installation de test capable d'opérer de manière satisfaisante jusqu'à des températures très basses, typiquement la température de l'azote liquide.

Plus précisément, l'invention a pour but de permettre d'effectuer des tests non seulement sur le composant électronique final, c'est-à-dire la puce, mais aussi sur la plaquette et sur les motifs simplifiés, c'est-à-dire avant que ne soit engagée la partie la plus onéreuse de la fabrication des composants semi-conducteurs.

L'invention a également pour but de fournir une installation permettant d'effectuer des tests sous des types d'excitations diverses, en particulier impulsionnelles, l'excitation pouvant être non seulement électrique, mais aussi optique et champ magnétique.

L'objet de l'invention est une installation pour le test de plaquettes de matériau semi-conducteur, qui sont au moins en partie traitées pour comporter des structures semi-conductrices électroniquement actives, munies en surface de plots de contact se présentant selon un motif prédéterminé. Le motif des plots de contact est un sous-ensemble du motif prédéterminé des puces que l'on va découper dans la plaquette.

L'installation proposée est du type comprenant, dans une enceinte sous atmosphère contrôlée, un dispositif porte-plaquette, un dispositif de contact électrique sélectif avec lesdits plots, et des moyens pour faire varier les conditions régnant dans l'enceinte, en particulier la température.

Selon une définition générale de l'invention, l'enceinte est constituée d'une cloche adaptable de façon étanche sur une plate-forme horizontale, plate-forme qui est percée d'un large orifice communiquant avec des moyens de mise sous vide secondaire, et d'au moins un passage étanche au vide. A l'intérieur de la cloche, la plate-forme supporte une table rigide dont le plateau bas reçoit le dispositif porte-plaquette, et le plateau haut, échancré au centre, reçoit le dispositif de contact. Le dispositif porte-plaquette comprend, de bas en haut :

. un mécanisme de positionnement capable au moins de translation bi-directionnelle, dans le plan horizontal, ainsi que d'un déplacement entre butées, d'excursion prédéterminée, dans le plan vertical,

. ce mécanisme supportant un insert thermiquement isolant, qui supporte à son tour une tête porte-plaquette,

. cette tête porte-plaquette comportant une cavité interne à chicanes, communiquant avec des conduites de transport d'un gaz liquéfié, en particulier de l'azote liquide, traversant ledit passage étanche. Un autre passage étanche permet le passage de l'alimentation d'un chauffage électrique incorporé à la tête et des connexions d'une sonde de température, logée dans la tête, au voisinage immédiat de sa face supérieure, où est fixée la plaquette.

Par ailleurs, du dispositif de contact électrique sélectif dépendent, à travers l'échancrure centrale du plateau supérieur, des aiguilles conductrices ajustables en position selon trois directions X, Y, Z, pour correspondre audit motif de contact prédéterminé, tandis que ce dispositif de contact sélectif est connecté par ailleurs à des liaisons isolées traversant le passage étanche. Enfin, la cloche comporte une fenêtre optique propre à l'illumination et/ou observation de la plaquette à travers ladite échancrure.

De préférence, il dépend également du plateau supérieur de la table une potence propre à supporter un écran thermique, au voisinage immédiat de la plaquette. De son côté, l'insert est un bloc d'isolant muni vers le haut de pieds, soutenant la tête porte-plaquette, pieds entre lesquels est monté un autre écran thermique. L'ensemble étant mis sous vide secondaire, ces deux écrans thermiques assurent une excellente isolation de la plaquette, ainsi que de ses moyens de régulation de température. Les écrans thermiques comprennent avantageusement un matériau isolant thermique multicouches réfléchissant.

L'objet de l'invention peut être complété par des moyens d'excitation magnétiques. Il est prévu ici que la potence peut également supporter, au-dessus de l'écran thermique haut, un anneau creux, en cuivre, logeant intérieurement un bobinage, et muni en périphérie externe d'un circuit de fluide de refroidissement (tel que de l'eau sous pression). La partie centrale de l'anneau est formée d'une pièce polaire annulaire en fer doux de forme tronconique, convergeant vers la plaquette, et laissant en son centre le passage aux aiguilles de contact. Les alimentations en électricité et en fluide de refroidissement longent la potence pour rejoindre le passage étanche précité.

En pratique, le mécanisme de positionnement comprend, de bas en haut :
- un équipage de mouvement horizontal pas à pas X-Y,
- un équipage de rotation pas à pas dans le plan horizontal, et
- un équipage de mouvement vertical entre butées, sur commande, qui supporte ledit insert.

Le dispositif de contact électrique peut comprendre des moyens motorisés pour ajuster individuellement la position des aiguilles.

Le dispositif de contact électrique peut également comprendre une carte porte-aiguilles de géométrie figée, correspondant à celle du motif de contact prédéterminé.

Le mouvement vertical peut être effectué par un moteur pas à pas asservi à la position d'une aiguille à détection de contacts.

Plus particulièrement, la tête de porte-plaquette comprend une résistance chauffante blindée, fixée par projection de métal fondu sur la paroi supérieure de sa cavité interne. De son côté, la face supérieure de la tête comporte deux guides, perpendiculaires, à face de guidage rentrante vers la tête, et des lames-ressort propres à solliciter la plaquette vers ces guides. Ceci assure un excellent maintien de la plaquette sur la tête, avec une grande surface de contact pour les échanges thermiques. On sait en effet que les plaquettes, une fois traitées, ont souvent perdu leur planéité rigoureuse initiale.

D'autres caractéristiques et avantages de l'invention apparaîtront à l'examen de la description détaillée ci-après, et des dessins annexés, sur lesquels :
- la figure 1 est un schéma de principe général de l'installation selon l'invention ;
- la figure 2 est un schéma plus détaillé de l'enceinte et de son contenu, tandis que la figure 2A en est une vue partielle schématique en perspective;
- les figures 3 et 3A sont respectivement une vue en coupe et une vue de dessus de la tête porte-plaquette ;
- les figures 4 et 4A sont respectivement une vue en coupe de la source d'excitation magnétique, et une illustration schématique du fonctionnement des porte-aiguilles ;
- la figure 5 est une vue en élévation schématique des différents moyens constituant l'ensemble porte-plaquette.

Les dessins annexés comportent des éléments de caractère certain. Ils sont donc à considérer comme partie intégrante de la description, et pourront servir non seulement à mieux faire comprendre celle-ci, mais aussi à la définition de l'invention, le cas échéant.

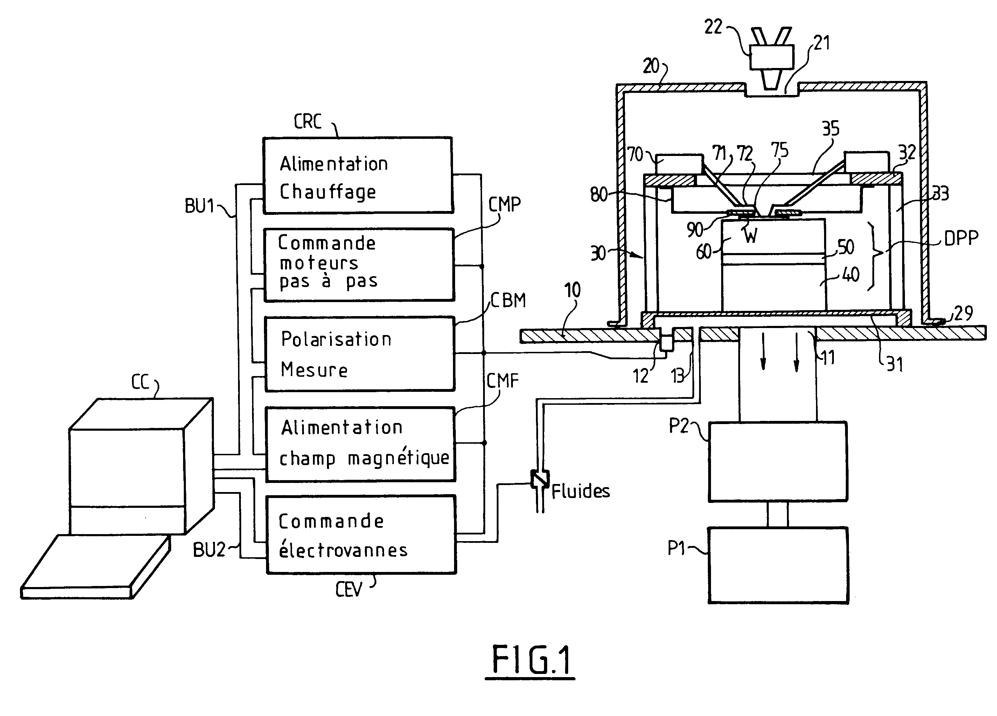

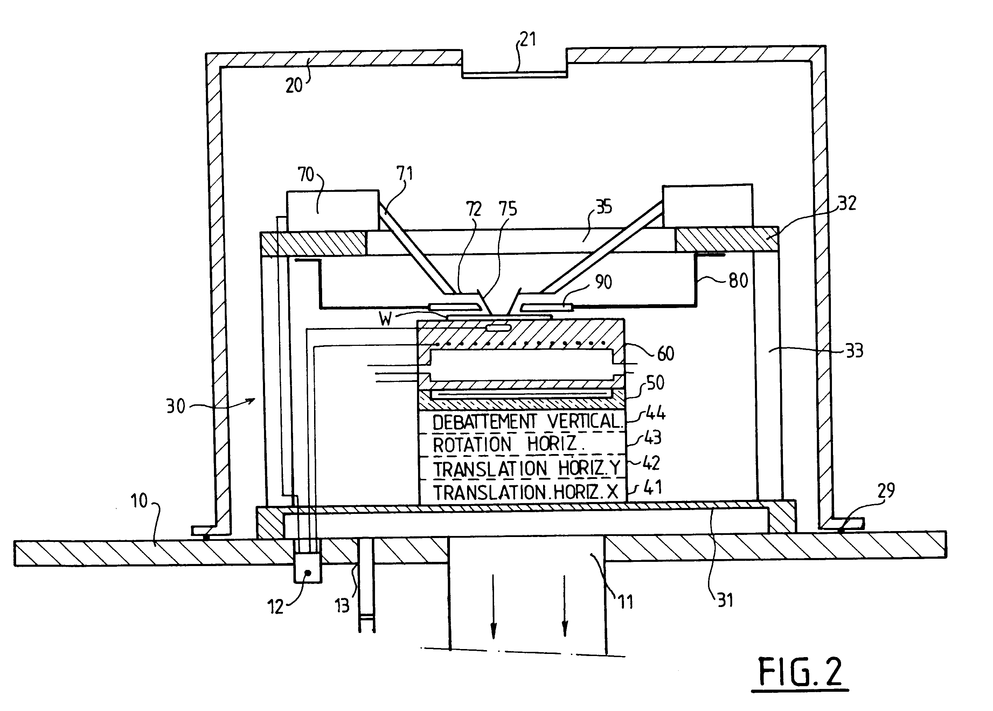

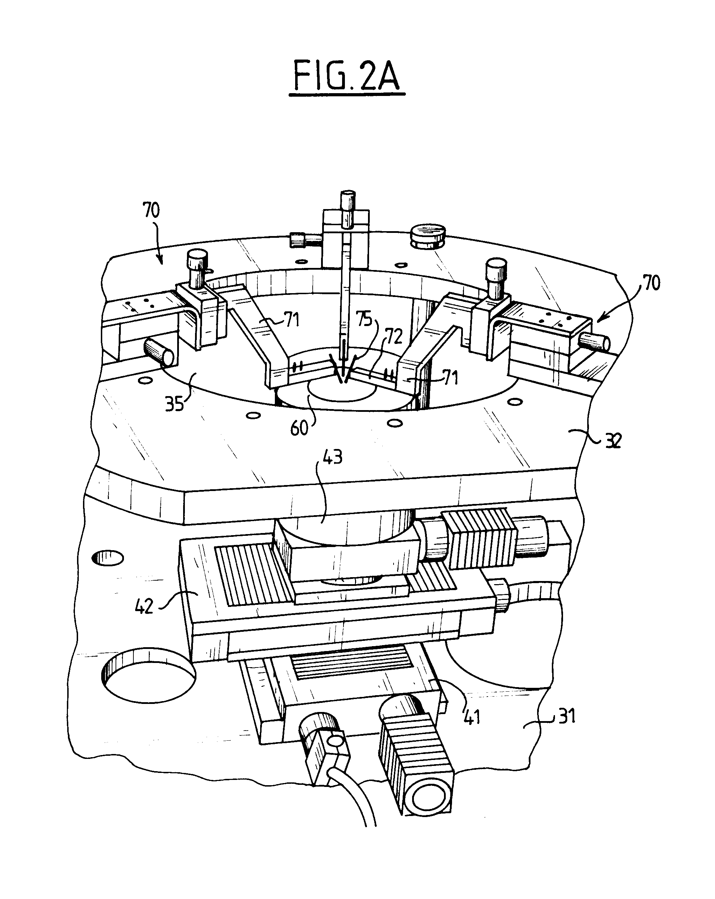

Sur les figures 1 et 2, la référence 10 désigne une plate-forme horizontale percée d'un large orifice 11 communiquant avec des moyens de mise sous vide secondaire constitués de pompes P1 et P2. La plate-forme 10 est également munie de deux traversées étanches, dont l'une 12 est consacrée aux circuits électriques, tandis que l'autre 13 est consacrée aux circuits de fluide.

Une cloche 20 peut venir se poser sur la plate-forme 10, avec interposition d'un joint torique 29. La mise sous vide assure l'étanchéité entre la cloche et la plate-forme.

Intérieurement, la plate-forme comporte une table 30, constituée d'un plateau inférieur 31 qui est en réalité une bride munie de trois ou quatre pieds, reposant sur la plate-forme 10. De cette bride partent des entretoises longues 33, supportant le plateau supérieur 32 de la table. Dans ce plateau est ménagée une large échancrure centrale 35.

Le plateau inférieur 31 reçoit le dispositif porte-plaquette DPP, lequel est constitué, de bas en haut, d'un mécanisme de positionnement 40, d'un insert isolant 50, et de la tête porte-plaquette 60, sur laquelle on distingue la plaquette W.

Le plateau supérieur 32 supporte un dispositif de contact, constitué d'une pluralité de porte-aiguilles. Pour chaque aiguille, il est prévu un moyen de positionnement horizontal d'un bras descendant 71, suivi d'un parallélogramme 72, à l'extrémité duquel est placé l'aiguille 75.

Enfin, sous le plateau 32 est fixée une potence 80 qui vient maintenir en regard de la plaquette un écran thermique, percé au centre pour laisser passage aux aiguilles, et complété avantageusement d'un dispositif d'excitation magnétique, comme on le verra plus loin.

Le haut de la cloche 20 est muni d'une fenêtre 21, optiquement transparente, pour permettre aussi bien l'observation de la plaquette sous loupe binoculaire 22 que le passage de signaux optiques d'excitation de la plaquette.

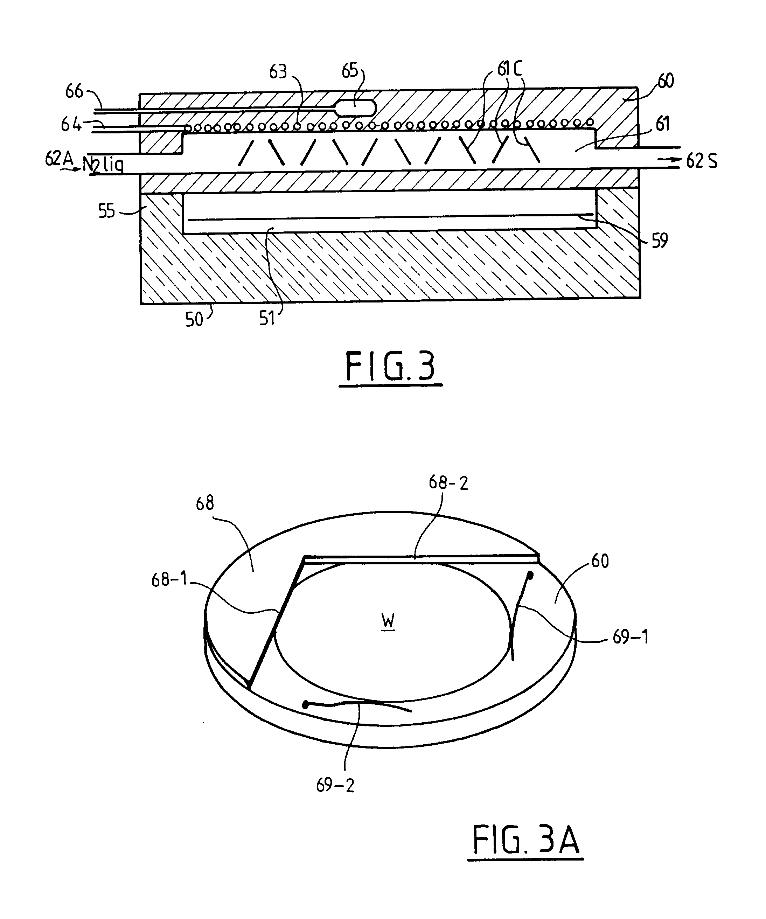

Les figures 2 et 3 montrent la structure interne de la tête porte-plaquette 60, et de l'insert 50.

L'insert 50 est constitué d'un bloc de matériau isolant tel que le KENOL (marque déposée), surmonté de pieds périphériques 55 par exemple au nombre de 3. Entre ces pieds est disposé un écran thermique bas 59 qui peut être constitué en un matériau isolant thermique réfléchissant multi-couches du type MLI ("multi layer isolator").

Les pieds 55 supportent la tête 60, qui comporte intérieurement une alvéole 61, où l'on a représenté schématiquement des chicanes 61C. L'alvéole 61 est traversée par de l'azote liquide, venant de la conduite d'admission 62A pour sortir par la conduite 62S. La tête 60 est en principe réalisée en deux parties, qui sont soudées après usinage des chicanes 61C. Cette faculté de montage permet aussi d'implanter une résistance 63 sur la paroi supérieure de l'alvéole. Cette résistance est, par exemple, réalisée dans le matériau dit "THERMOCOAX" (marque déposée). Ce matériau est fixé par projection de métal fondu ("schoopage"). Les lignes d'alimentation de la résistance sont visibles en 64.

Enfin, on ménage à l'intérieur de la tête 60, entre cette résistance et sa face supérieure, une petite cavité 65 dans laquelle est placée une sonde thermique de précision, munie de liaisons 66. Cette sonde thermique est, par exemple, une sonde de température constituée d'une résistance de platine, de résistance 100 Ω à 0°C.

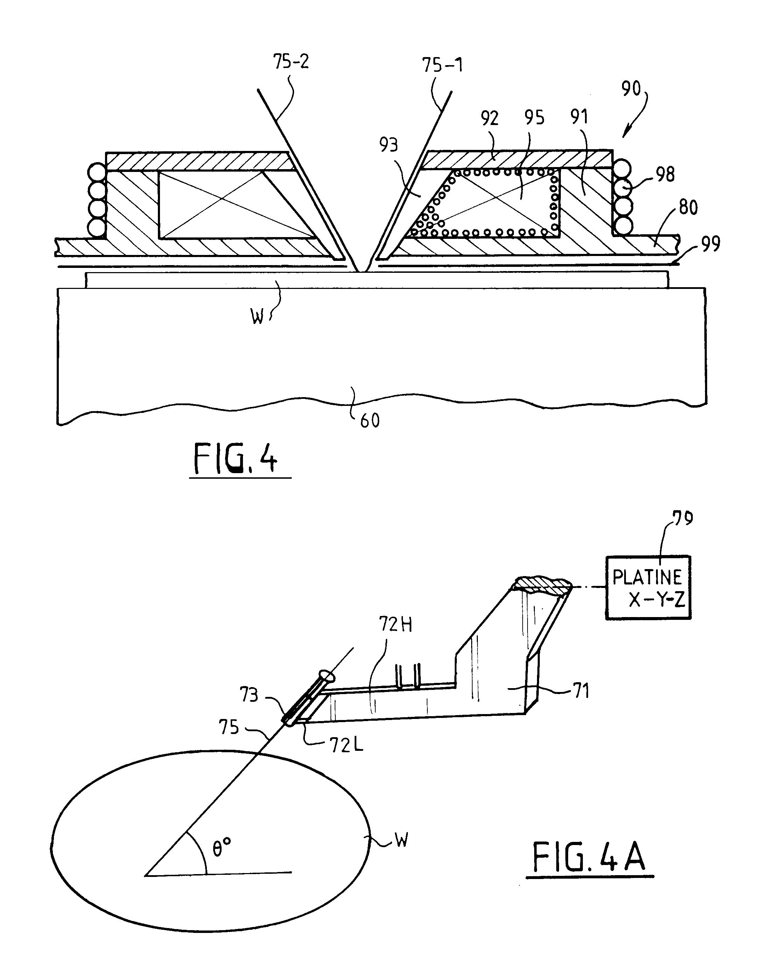

La mise en place de la plaquette au-dessus de la tête 60 peut être réalisée de différentes manières. Toutefois, pour tenir compte de légères déformations de la plaquette W subies au cours du traitement, il est préférable d'utiliser le moyen illustré sur la figure 3A. La tête 60 est munie en partie supérieure d'une équerre 68 formant deux guidages perpendiculaires 68-1 et 68-2, dont la face de guidage définit un angle aigu avec le plan supérieur de la tête 60. On sait que les plaquettes W ont en général deux méplats. Ces deux méplats, perpendiculaires, peuvent venir se placer sur les deux guidages, qui tendent par nature à appliquer la plaquette sur la tête 60, pourvu que celle-ci soit sollicitée dans le plan horizontal vers les guidages, comme c'est le cas ici par les deux ressorts de rappel schématisés en 69-1 et 69-2. Ce montage procure à la fois un excellent positionnement de la plaquette W, et un bon contact avec la tête, ce qui améliore les échanges thermiques et par conséquent l'identité entre la température de la plaquette et celle de la tête 60. Il est rappelé que l'ensemble plaquette W-tête 60 se trouve pris en sandwich entre deux écrans thermiques 99 en haut (décrit plus loin en référence à la figure 4) et 59 en bas (figure 3).

La figure 4 illustre très schématiquement la tête 60 supportant la plaquette W.

Au-dessus de cet ensemble est illustré en coupe schématique le dispositif tenu par la potence 80 des figures 1 et 2. Cette potence 80 se termine vers le centre par une pièce en forme de disque supportant un élément tubulaire saillant verticalement 91, toute cette partie étant en matériau conducteur thermique. Le tube 91 supporte un disque plat 92, dont l'orifice central est en forme de V à pointe tournée vers le bas. Entre la périphérie centrale du disque 92 et la périphérie centrale 85 de la potence 80 est montée une pièce polaire 93. Cette pièce est de forme générale annulaire, et délimitée par deux troncs de cône convergeant et se rapprochant vers le bas.

L'ensemble des pièces 80, 91, 92 et 93 définit un logement annulaire où est placé un solénoïde en cuivre 95, illustré schématiquement.

L'écran thermique 99 est fixé par en dessous sur la potence 80, et naturellement percé en son centre pour laisser passer les aiguilles telles 75-1 et 75-2, qui vont être positionnées en longeant la pièce annulaire tronconique 93.

Par ailleurs, les pièces 91 et 92 sont agencées pour former radiateur thermique, et la périphérie externe du tube 91 est munie d'une conduite 98 en spirale susceptible de recevoir, par exemple, de l'eau comme agent refroidissant. Malgré la très basse température de la tête supportant la plaquette, l'eau ne gèle plus dès lors qu'elle circule, et que par ailleurs l'écran thermique 99 et le vide limitent les échanges thermiques avec la tête 60 et la plaquette W.

Les fils d'alimentation du solénoïde de cuivre 95 et la conduite, en spirale ou en hélice, de refroidissement, 98, rejoignent respectivement, en longeant la potence 80 et un pied 33, la traversée électrique 12 et la traversée de fluide 13.

Ce montage élégant et simple permet d'obtenir des champs magnétiques élevés au voisinage de la partie explorée de la plaquette, par un choix convenable des matériaux, et en particulier de l'anneau tronconique 93. Il évite d'avoir à mettre en oeuvre un aimant de très grande taille, extérieur, et nécessitant l'utilisation d'une alimentation électrique de grande puissance pour obtenir un champ électrique équivalent.

La figure 4A illustre de façon schématique le maintien d'une aiguille 75 sur la plaquette W.

Une platine de mouvements X, Y, Z (c'est-à-dire trois axes en translation), référencée 79, permet de déplacer le bras 71, sur une pointe 78 duquel se trouvent fixées deux lamelles 72H et 72L formant un parallélogramme, qui soutient une coulisse 73, dans laquelle peut être positionnée l'aiguille 75.

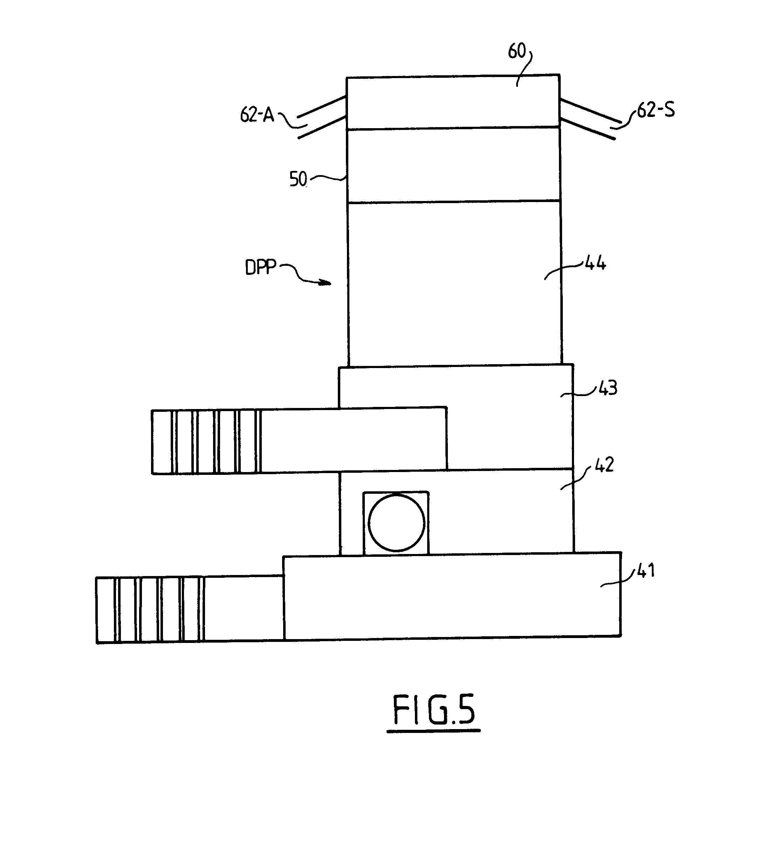

La figure 5 rappelle schématiquement la structure du dispositif porte-plaquette DPP.

On y retrouve l'insert 50, la tête 60 et un ensemble mécanique comprenant le dispositif pas à pas 41 pour le mouvement dans la direction horizontale X, le dispositif 42 pour le mouvement pas à pas dans la direction Y, le dispositif 43 pour la commande en rotation dans le plan horizontal X-Y et un dispositif 44 assurant un déplacement vertical des éléments situés au-dessus. Ce déplacement vertical peut être obtenu par différents moyens : électro-aimant, vérin pneumatique, ou mieux moteur électrique pas à pas. On prévoira naturellement des butées d'amortissement convenables pour éviter un choc trop violent lorsque le dispositif d'entraînement 44 amène la plaquette située au-dessus de la tête 60 en contact avec les aiguilles.

Cette tête 60 peut être constituée de différents matériaux, mais l'on utilisera de préférence un alliage comme l'INVAR cryogénique.

L'ensemble de l'appareil est commandé par un micro-ordinateur CC, possédant un ou plusieurs bus BU1 et BU2 (Fig. 1).

Le bus BU1 commande des circuits électriques de pilotage qui sont :

- le circuit CRC pour l'alimentation du chauffage par la résistance 63, en fonction de la température captée par la sonde 65 ;
- les circuits CMP pour la commande des moteurs pas à pas assurant, d'une part, le positionnement du mécanisme 40, d'autre part, éventuellement celui des dispositifs porte-aiguilles 70,
- un circuit CMF pour l'alimentation de la bobine 95 susceptible d'appliquer un champ magnétique à la plaquette W ;
- un circuit CBM pour l'application de tensions de polarisation aux aiguilles individuelles du porte-aiguilles ou de la carte à pointes.

Un circuit CEV est alimenté par le bus BU2, pour commander les différentes électrovannes schématisées en EVx, et qui assurent, d'une part, l'alimentation en azote liquide, en fonction de la température mesurée par la sonde 65, d'autre part, l'alimentation en eau de refroidissement de la conduite 98, qui peut dépendre de la même mesure de température et, enfin l'alimentation du dispositif à vérins 44 permettant le déplacement vertical de la plaquette.

En laboratoire, le dispositif est utilisé de la manière suivante :

- les aiguilles sont tout d'abord positionnées individuellement avec précision quant à leur pointe, à l'aide de la loupe binoculaire 22 en observation à travers la fenêtre 21,
- elles peuvent alors être positionnées horizontalement une par une, sous la même observation, pour correspondre aux plots du motif de test des transistors.
- dès lors que le positionnement initial des aiguilles en fonction du motif voulu est ainsi réalisé, il n'est plus nécessaire de le retoucher ;
- c'est ensuite la plaquette qui sera déplacée vers le bas puis réorientée à l'aide des mécanismes 40, pour être ensuite amenée en contact avec la tête dans la position horizontale et avec l'angle horizontal voulu pour permettre l'examen d'un autre motif de test, identique au précédent, mais situé à un endroit différent de la plaquette.

Le dispositif qui vient d'être décrit permet donc a priori d'effectuer toutes sortes de mesures sur des motifs de test réalisés dans des plaquettes découpées en tête et en queue d'un lingot.

L'un des avantages essentiel de l'installation proposée est qu'il permet de telles mesures sur l'ensemble de la plaquette, et à des températures pouvant aller de celle de l'azote liquide jusqu'à la température ambiante ou à des températures qui la dépassent d'une centaine de degrés. En d'autres termes, les températures utiles s'échelonnent de -190°C environ jusqu'à 200°C environ.

Les tests électriques effectués sur une telle gamme de températures sont particulièrement intéressants pour détecter des effets indésirables, tels que l'effet de substrat décrit plus haut. De plus, en permettant d'opérer à température très basse, on accède beaucoup plus facilement à une discrimination entre les différentes sources possibles d'un comportement inadéquat du matériau semi-conducteur, puisque les perturbations thermiques de la structure cristalline sont d'autant plus faibles que la température est basse : en d'autres termes, les mesures sont d'autant plus sensibles à la qualité du matériau que la température est basse.

Ainsi, on peut, par exemple, effectuer des mesures de courant de canal d'un transistor en fonction de la température, depuis la température de l'azote liquide jusqu'à des températures de 300°K.

Ce qui vient d'être décrit est basé sur une mesure de la conductance d'un transistor en fonction de la température. Elle permet de localiser les défauts de la couche semi-conductrice active avec une sensibilité nettement accrue par rapport aux méthodes de test actuellement disponibles.

L'utilisation de motifs de test appropriés permet de visualiser les dispersions électriques présentées par la couche semi-conductrice sur l'ensemble de la plaquette semi-conductrice.

La présente invention permet d'appliquer à la plaquette, en combinaison avec ce qui précède ou séparément, une excitation magnétique (bobine 98), optique (illumination à travers la fenêtre 21) et bien entendu thermique.

De telles mesures ne pouvaient être effectuées jusqu'à présent que sur une gamme de températures nettement plus étroite, ou sur une puce semi-conductrice, et non sur une plaquette toute entière ; de plus, elles ne pouvaient pas être effectuées dans un seul et même appareil. Indépendamment de l'économie, il en résulte un gain de temps considérable car l'utilisation d'un seul appareil devant opérer sous vide et descendre à très basse température s'accompagne habituellement d'un temps mort considérable à chaque chargement d'une plaquette.

En bref, l'installation proposée permet donc de réaliser des évaluations sur des motifs appropriés répartis sur une même plaquette. En outre, elle offre la possibilité d'effectuer :

- des mesures cartographiques d'effet HALL (excitation magnétique) et de conductivité, depuis la température de l'azote liquide jusqu'à l'ambiante,
- des mesures d'effet HALL et de conductivité en fonction de la température sur un motif de test donné,
- des mesures cartographiques d'effet substrat à toutes températures comprises entre -190 et +100°C au moins,
- des mesures sur un motif test d'effet substrat sélectif en fonction de la température.

On notera tout particulièrement la possibilité d'obtenir la cartographie des constantes de temps de commutation du courant canal d'un composant ou transistor, après commutation des tensions sur la grille, à température fixe, essai souvent dénommé "LAG-IN".

L'appareil rend bien entendu possibles également des mesures extrêmement sophistiquées comme celles connues sous le nom DLTS (pour "Deep Level Transient Spectroscopy"), ou de PITS (pour "Photon Induced Transient Spectroscopy").

Plus généralement, tout type de mesure optique cartographique tel qu'une absorption optique ou une photoluminescence peut être effectuée sous forme cartographique et/ou à températures variables, de manière couplée ou non avec des mesures électriques.

L'appareil selon l'invention pourra naturellement être utilisé également en fabrication industrielle. Dans ce cas, les mêmes types de mesures que précédemment sont possibles. Mais l'on aura souvent intérêt à utiliser un dispositif porte-pointes simplifié, constitué par exemple d'une carte portant des pointes en position fixe avec l'inclinaison voulue. En effet, le motif des plots de contact étant en principe le même sur tous les motifs de test, il n'est pas nécessaire de positionner individuellement les aiguilles.

Dans ce qui précède, on a indiqué que l'invention s'appliquait en particulier à des mesures d'effet substrat, observé jusqu'à présent avec des matériaux du type dit III-V, tels que l'arséniure de gallium, ou les dispositifs semi-conducteurs à hétéro-structure utilisant de tels matériaux. Bien entendu, l'installation proposée peut avoir une application plus large, et s'appliquer tout aussi bien à des plaquettes de silicium.

Bien entendu, l'invention n'est pas limitée aux modes de réalisation décrits, et peut offrir de nombreuses variantes.

Par exemple, bien que le recours à une fenêtre optique 21 à travers la cloche 20 soit particulièrement intéressant, il est envisageable de se dispenser d'une telle fenêtre pour une installation de test sur des fabrications de série, qui utiliserait une carte porte-pointes.

## Revendications

1. Installation pour le test de plaquettes de matériau semi-conducteur, au moins en partie traitées pour comporter des structures semi-conductrices électroniquement actives, munies en surface de plots de contact se présentant selon un motif prédéterminé, ladite installation comprenant, dans une enceinte sous atmosphère contrôlée, un dispositif porte-plaquette (DPP), un dispositif (70) de contact électrique sélectif avec lesdits plots, et des moyens pour faire varier les conditions régnant dans l'enceinte, en particulier la température, l'enceinte étant constituée d'une cloche (20) adaptable de façon étanche sur une plate-forme horizontale (10), plate-forme qui est percée d'un large orifice (11) communiquant avec des moyens de mise sous vide secondaire (P1,P2) et d'au moins un passage étanche au vide (12,13), la plate-forme (10) supportant une table rigide (30) dont le plateau bas (31) reçoit le dispositif porte-plaquette, et le plateau haut (32, échancré au centre (35), reçoit le dispositif de contact, caractérisée en ce que le dispositif porte-plaquette (DPP) comprend, de bas en haut,

. un mécanisme de positionnement (40) capable au moins de translation bi-directionnelle, dans le plan horizontal, ainsi que d'un déplacement entre butées, d'excursion prédéterminée, dans le plan vertical,

. ledit mécanisme supportant un insert thermiquement isolant (50), qui supporte à son tour une tête porte-plaquette (60),

. cette tête porte-plaquette (60) comportant une cavité interne (61) à chicanes (61C) communiquant avec des conduits (62) de transport d'un gaz liquéfié, traversant ledit passage étanche (13), de même (12) que l'alimentation d'un chauffage électrique (63) incorporé à la tête et que les connexions d'une sonde de température (65), logée dans la tête, au voisinage immédiat de sa face supérieure, où est fixée la plaquette (W),

en ce que du dispositif de contact sélectif (70) dépendent, à travers l'échancrure centrale (35) du plateau supérieur, des aiguilles conductrices (75), ajustables en position selon trois axes pour correspondre audit motif prédéterminé, tandis qu'il est connecté, par ailleurs, à des liaisons isolées traversant ledit passage étanche (12), et en ce que la cloche (20) comporte une fenêtre optique (21) propre à l'illumination et/ou observation de la plaquette à travers ladite échancrure.

2. Installation selon la revendication 1, caractérisée en ce qu'il dépend également du plateau supérieur (32) de la table une potence (80) propre à supporter un écran thermique (99), au voisinage immédiat de la plaquette (W), et en ce que l'insert (50) est un bloc d'isolant muni, vers le haut, de pieds (55) soutenant la tête porte-plaquette, pieds entre lesquels est monté un autre écran thermique (59).

3. Installation selon la revendication 2, caractérisée en ce que les écrans thermiques (99,59) comprennent un matériau isolant thermique multi-couches réfléchissant.

4. Installation selon l'une des revendications précédentes, caractérisée en ce que la potence (80) supporte, au-dessus de l'écran thermique (99), un anneau creux (90), logeant intérieurement un bobinage (95), et muni en périphérie externe d'un circuit de fluide de refroidissement (98), la partie centrale de l'anneau étant formée d'une pièce polaire annulaire (93) de forme tronconique, convergeant vers la plaquette, et laissant en son centre le passage aux aiguilles de contact (75), les alimentations électrique et en fluide de refroidissement longeant la potence (80) pour rejoindre ledit passage étanche (12).

5. Installation selon l'une des revendications précédentes, caractérisée en ce que le mécanisme de positionnement comprend, de bas en haut,

- un équipage (41,42) de mouvement horizontal pas à pas X-Y,
- un équipage (43) de rotation pas à pas dans le plan horizontal, et
- un équipage (44) de mouvement vertical entre butées, sur commande, qui supporte ledit insert.

6. Installation selon l'une des revendications précédentes, caractérisée en ce que le gaz liquéfié est de l'azote liquide.

7. Installation selon l'une des revendications précédentes, caractérisée en ce que le dispositif de contact électrique comprend des moyens motorisés (79) pour ajuster individuellement la position des aiguilles (75).

8. Installation selon l'une des revendications précédentes, caractérisée en ce que le dispositif de contact électrique (70) comprend une carte porte-aiguilles de géométrie figée, correspondant à celle du motif prédéterminé.

9. Installation selon l'une des revendications précédentes, caractérisée en ce que la tête (60) comprend une résistance chauffante blindée (63) fixée par projection de métal fondu sur la paroi supérieure de sa cavité interne (61).

10. Installation selon l'une des revendications précédentes, caractérisée en ce que la face supérieure de la tête comporte deux guides (68-1,68-2), perpendiculaires, à face de guidage rentrante vers la tête, et des lames-ressort (69-1,69-2) propres à solliciter la plaquette vers ces guides.

FIG.1

CRC
- Alimentation Chauffage
- Commande moteurs pas à pas
- Polarisation Mesure
- Alimentation champ magnétique
- Commande électrovannes

CEV

CC
BU1
BU2
CMP
CBM
CMF

Fluides

EP 0 477 453 A1

EP 0 477 453 A1

DEBATTEMENT VERTICAL
ROTATION HORIZ.
TRANSLATION HORIZ.Y
TRANSLATION.HORIZ.X

FIG.2

9

# FIG.2A

FIG.3

FIG. 3A

FIG. 4

FIG. 4A

FIG.5

**Office européen
des brevets**

# RAPPORT DE RECHERCHE EUROPEENNE

Numéro de la demande

**EP 90 40 2627**

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| E | FR-A-2 645 679   (ONERA)<br>* Document entier *<br>– – – | 1-10 | G 01 R 31/28 |
| Y | EP-A-0 349 042   (L.E.P. PHILIPS)<br>* Colonne 2, ligne 53 - colonne 3, ligne 48; colonne 4, lignes 16-56, figure 1 * | 1 | |
| A | – – – | 2,5,6,8,9 | |
| Y | N.T.I.S. TECH NOTES, vol. 10, no. 3, juin 1986, pages 57-58; A. CHMIELEWKSI et al.: "Measuring seebeck coefficients with large thermal gradients"<br>* Document entier *<br>– – – | 1 | |
| A | IDEM<br>– – – | 2,3 | |
| A | US-A-4 115 736   (TRACY)<br>* Résumé; colonne 2, lignes 1-13; colonne 3, lignes 39-46; colonne 4, lignes 23-26,43-53; figure 1 *<br>– – – | 1,7,10 | |
| A | PATENT ABSTRACTS OF JAPAN, vol. 11, no. 62 (P-551)[2509], 25 février 1987;<br>& JP-A-$^3$61 225 669 (SUMITOMO ELECTRIC IND. LTD) 07-10-1986<br>– – – | 1,4 | DOMAINES TECHNIQUES RECHERCHES (Int. Cl.5)<br><br>G 01 R<br>H 01 L |
| A | EP-A-0 003 933   (S.A. DE TELECOMMUNICATIONS)<br>* Abrégé; figures 1,2 *<br>– – – – – | 7 | |

Le présent rapport de recherche a été établi pour toutes les revendications

| Lieu de la recherche | Date d'achèvement de la recherche | Examinateur |
|---|---|---|
| La Haye | 26 avril 91 | SINAPIUS G.H. |